Europäisches Patentamt

European Patent Office

Office européen des brevets

(19)

(11) **EP 0 838 902 A1**

(12) **DEMANDE DE BREVET EUROPEEN**

(43) Date de publication:
**29.04.1998 Bulletin 1998/18**

(51) Int. Cl.$^6$: **H03M 1/06**, H04N 5/18,
H04N 9/72, G06G 7/20

(21) Numéro de dépôt: **97203201.5**

(22) Date de dépôt: **14.10.1997**

(84) Etats contractants désignés:
**AT BE CH DE DK ES FI FR GB GR IE IT LI LU MC NL PT SE**

(30) Priorité: **25.10.1996 FR 9613066**

(71) Demandeur:
**Philips Electronics N.V.
5621 BA Eindhoven (NL)**

(72) Inventeur: **Belin, Philippe
75008 Paris (FR)**

(74) Mandataire: **Caron, Jean
Société Civile S.P.I.D.
156, Boulevard Haussmann
75008 Paris (FR)**

(54) **Dispositif d'alignement d'un niveau de tension continue**

(57) Le dispositif comprend un convertisseur analogique/numérique (8) et un module de régulation pour l'auto-ajustage de la composante continue. Ce module comprend un comparateur analogique (5) qui réalise une comparaison entre le signal analogique (11) à l'entrée du convertisseur analogique/numérique (8), et une tension de référence (10) fabriquée à partir des tensions qui alimentent l'échelle de résistances (9) du convertisseur.

Pour que la régulation n'introduise pas de bruit dans le signal délivré, le comparateur (5) du module de régulation présente une réponse non-linéaire, avec un gain sortie/entrée diminué pour une plage du signal différentiel de régulation centrée autour de zéro.

Applications : traitement numérique d'images.

FIG. 1

## Description

La présente invention concerne un dispositif d'alignement d'un niveau de tension continue, présentant une entrée dite analogique destinée à recevoir une tension analogique d'entrée et une sortie numérique destinée à délivrer un signal numérique résultant de la conversion analogique/numérique d'une tension analogique obtenue à partir de la tension d'entrée, comprenant un convertisseur analogique/numérique muni d'une entrée analogique reliée à l'entrée du dispositif et reliée via une capacité dite de stockage à une source de potentiel continu fixé, et d'une sortie constituant la sortie du dispositif, et un module de régulation, muni d'un comparateur analogique recevant en entrée un signal différentiel dit de régulation constitué d'un premier signal qui est un signal de valeur fixe prédéterminée et d'un second signal qui est un signal représentatif du signal d'entrée du convertisseur, ce module de régulation délivrant en sortie un signal permettant l'ajustement de la tension aux bornes de la capacité de stockage, et étant activé lorsque la tension analogique d'entrée présente un palier dit de référence.

Un tel dispositif est utilisé, entre autres, dans des appareils de traitement numérique d'images. Le module de régulation a pour but l' auto-ajustage de la composante continue dans le signal délivré.

Un dispositif d'alignement du niveau de tension continue selon l'introduction ci-dessus est connu du brevet US-5,371,552. Dans le dispositif selon ce document, le module de régulation comprend un comparateur analogique qui réalise une comparaison entre le signal analogique à l'entrée du convertisseur analogique/numérique proprement dit, et une tension de référence fabriquée à partir des tensions qui alimentent l'échelle de résistances de ce convertisseur.

Un objet de l'invention est d'améliorer les performances d'un tel dispositif d'alignement d'un niveau de tension continue.

A cet effet, dans un dispositif selon l'invention, le comparateur du module de régulation présente une réponse non-linéaire, avec un gain sortie/entrée diminué pour une plage déterminée du signal différentiel de régulation, plage centrée autour de zéro.

Ceci a l'avantage que la régulation de la composante continue dans le signal délivré n'introduit pratiquement pas de bruit dans ce signal.

On pourrait imaginer un système numérique, avec un comparateur numérique dont la valeur de sortie serait multipliée numériquement par un chiffre variable, ou bien dans lequel on commuterait des sources de courant de diverses valeurs, afin d'obtenir l'équivalent d'un gain diminué ou augmenté. Un tel dispositif numérique risquerait toutefois d'introduire une instabilité dans la conversion analogique/numérique, à cause des discontinuités de sa commande.

Avantageusement, le module de régulation comprend :

- des moyens pour engendrer, à partir du premier et du second signal constituant le signal différentiel de régulation, deux signaux différentiels décalés en tension continu l'un par rapport à l'autre, l'un étant appelé "haut" et l'autre "bas", chacun étant constitué d'un premier et d'un second signal correspondant respectivement au premier signal et au second signal constituants du signal différentiel de régulation,
- des moyens pour engendrer un courant, dit de commande, qui est fonction de la somme de deux termes : d'une part la différence entre le premier signal constituant du signal différentiel haut et le second signal constituant du signal différentiel bas, d'autre part la différence entre le second signal constituant du signal différentiel haut et le premier signal constituant du signal différentiel bas,
- et un amplificateur différentiel, dont le gain est fonction du dit courant de commande, pour amplifier le signal différentiel de régulation.

Dans un mode de réalisation avantageux :

- les moyens pour engendrer deux signaux différentiels décalés comprennent, pour chacun des premier et second signaux constituants du signal différentiel de régulation, un premier et un second étage de type dit "suiveur", chacun muni d'une charge fractionnée, le premier signal constituant du signal différentiel haut et le premier signal constituant du signal différentiel bas étant respectivement prélevés aux bornes d'une fraction de la charge du premier étage suiveur, le second signal constituant du signal différentiel haut et le second signal constituant du signal différentiel bas étant respectivement prélevés aux bornes d'une fraction de la charge du second étage suiveur,
- les moyens pour engendrer le courant de commande comprennent deux paires de transistors, dites paires différentielles, munies chacune d'un premier et d'un second transistor, la base du premier transistor de la première paire recevant le premier signal constituant du signal différentiel haut, et celle du second transistor recevant le second signal constituant du signal différentiel bas, la base du premier transistor de la seconde paire recevant le second signal constituant du signal différentiel haut, et celle du second transistor recevant le premier signal constituant du signal différentiel bas, les courants de collecteur des premiers / seconds transistors des deux paires étant ajoutés l'un à l'autre,
- l'amplificateur différentiel comprend une paire de transistors, dite paire différentielle, aux entrées de laquelle est appliqué le signal différentiel de régulation, paire dans laquelle les émetteurs des deux transistors reliés l'un à l'autre reçoivent le dit courant de commande, éventuellement reproduit au moyen de miroirs de courant, les deux transistors de la paire différentielle étant avantageusement chargés chacun par un transistor de charge, les deux transistors de charge formant ensemble un miroir de courant, de façon que l'amplificateur différentiel présente une sortie de courant, et une armature de la capacité de stockage est reliée à cette sortie de courant.

Dans un mode de réalisation particulier, l'entrée analogique du convertisseur analogique/numérique est reliée à l'entrée analogique du dispositif via une capacité et à une entrée dite de référence, destinée à recevoir une tension de référence, via une résistance, et un deuxième amplificateur différentiel est placé entre l'entrée analogique du convertisseur analogique/numérique et l'entrée analogique du dispositif, amplificateur présentant une première entrée reliée à l'entrée du dispositif et une deuxième entrée reliée à une borne d'alimentation via la capacité de stockage, et une sortie reliée à l'entrée du convertisseur analogique/numérique.

Le convertisseur analogique/numérique étant muni d'une échelle de résistances soumise à une différence de potentiel donnée, échelle fournissant à chaque noeud intermédiaire entre deux résistances une tension de référence d'échelle utilisée par le convertisseur à des fins de comparaison avec un signal reçu sur son entrée analogique, le signal de régulation est élaboré de préférence à partir d'au moins une des dites tensions de référence d'échelle, par exemple l'un des signaux constituants du signal de régulation est l'une des tensions de référence d'échelle.

Ces aspects de l'invention ainsi que d'autres aspects plus détaillés apparaîtront plus clairement grâce à la description suivante d'un mode de réalisation constituant un exemple non limitatif.

La figure 1 représente schématiquement un dispositif d'alignement d'un niveau de tension continue, destiné à des applications de télévision.

La figure 2 représente plus en détail un module de régulation réalisé sous forme intégrée.

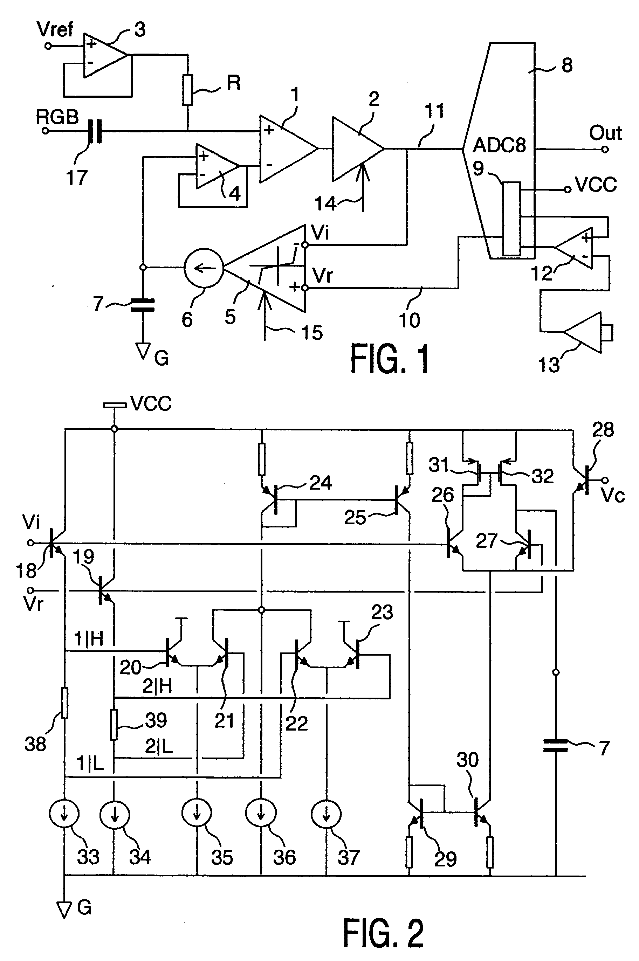

Le dispositif d'alignement d'un niveau de tension continue représenté par la figure 1 comporte une entrée dite analogique, indiquée par la référence "RGB", destinée à recevoir une tension analogique d'entrée. Il s'agit par exemple d'une des composantes de couleur d'une image dans un récepteur de télévision ou dans un moniteur d'ordinateur. Pour ce genre d'application, les fréquences des signaux peuvent atteindre plusieurs mégahertz et la précision d'un convertisseur huit bits est satisfaisante. Il est important que le niveau de la composante continue, appelé niveau du noir, soit bien régulé. Le convertisseur selon l'invention permet d'obtenir une telle régulation, sans apporter de bruit néfaste.

Le dispositif possède une sortie numérique, indiquée par la référence "Out", destinée à délivrer un signal numérique résultant de la conversion de la tension analogique d'entrée.

L'entrée (RGB) du dispositif est reliée à l'entrée analogique 11 d'un convertisseur analogique/numérique 8. Cette liaison est faite ici via une capacité de liaison 17 et via un amplificateur 1, dont le branchement sera expliqué plus en détail ci-après. La sortie du convertisseur 8 constitue la sortie (Out) du dispositif.

L'amplificateur 1 est de type différentiel à deux entrées. L'entrée RGB du dispositif est reliée à son entrée "+" via la capacité 17. Une entrée Vref destinée à recevoir une tension de référence, est reliée également à cette entrée "+", via un amplificateur adaptateur d'impédance 3 et une résistance R. L'entrée "-" est reliée via une capacité 7 dite de stockage à une source de potentiel continu fixé, ici la masse. La sortie de l'amplificateur 1 est reliée, via un autre amplificateur 2, à l'entrée du convertisseur analogique/numérique 8. Cet amplificateur 2, qui ne fait pas partie de l'invention, est un modèle à gain réglable par une entrée de commande de gain 14, et permet d'étalonner le dispositif.

Un module dit de régulation sert à ajuster le niveau du noir. Il est constitué essentiellement par les éléments 5-6. Un comparateur 5 reçoit sur son entrée Vr·Vi un signal différentiel dit de régulation. Ce signal est constitué d'un premier signal, appliqué à l'entrée Vi, et d'un second signal, appliqué à l'entrée Vr. Le premier signal 11, appliqué à l'entrée Vi, est un signal représentatif du signal d'entrée du convertisseur analogique/numérique 8. Ici il s'agit simplement de ce signal lui même. Le second signal 10, appliqué à l'entrée Vr, est un signal de valeur prédéterminée. Le comparateur est activé, lorsque la tension analogique d'entrée présente un palier dit de référence, au moyen d'une entrée 15 reliée à un circuit connu, non représenté, et qui ne fait pas partie de l'invention. Le comparateur délivre en sortie un signal qui commande le courant d'un générateur de courant 6, dont le courant est amené à la capacité de stockage 7 pour la charger ou la décharger. Le module de régulation permet donc l'ajustement de la tension aux bornes de cette capacité.

Un amplificateur 4 branché en suiveur, est disposé entre la capacité 7 et l'entrée de l'amplificateur 1, ce qui permet de rendre très faible le courant absorbé, et d'éviter une dérive de la tension aux bornes de la capacité 7.

Le convertisseur analogique/numérique 8 est muni d'une échelle 9 de résistances, fournissant à chaque noeud intermédiaire entre deux résistances une tension de référence d'échelle utilisée par le convertisseur à des fins de comparaison avec le signal reçu sur son entrée analogique. L'échelle est branchée entre une tension d'alimentation VCC et la sortie d'un amplificateur 12 à deux entrées, monté de façon connue, avec son entrée "+" connectée à un point intermédiaire de l'échelle 9, et son entrée "-" connectée en sortie d'un amplificateur 13 dont les deux entrées sont interconnectées. L'amplificateur 13 est la recopie de l'amplificateur 1 et il a pour but de reproduire la tension parasite de décalage, dite "offset", de ce dernier, ce qui a un effet de compensation. Le signal de régulation est élaboré à partir d'une des dites tensions de référence d'échelle : le signal 10, constituant du signal de régulation, est prélevé à un point intermédiaire de l'échelle 9. C'est donc ici l'une des tensions de référence d'échelle de cette échelle, par exemple celle qui doit correspondre au niveau du noir dans le signal 11.

Comme indiqué par la figure dessinée dans le triangle représentant le comparateur 5, ce dernier présente une réponse non-linéaire, avec un gain sortie/entrée diminué pour une plage du signal différentiel de régulation centrée autour de zéro.

Le module de régulation est représenté par la figure 2. Un premier signal et un second signal, qui constituent à eux deux le signal différentiel de régulation, sont appliqués respectivement à l'entrée Vi et à l'entrée Vr. A partir des deux entrées Vi et Vr sont engendrés deux signaux différentiels décalés en tension continue l'un par rapport à l'autre. L'un sera appelé "haut", et l'autre "bas", chacun étant constitué d'un premier et d'un second signal correspondant respectivement au premier signal Vi et au second signal Vr. A chacune des entrées Vi et Vr est connectée respectivement une entrée d'un premier étage et une entrée d'un second étage, constitués respectivement par les transistors 18 et 19 montés en "émetteur suiveur". Chacun de ces transistors est muni d'une charge fractionnée constituée d'une résistance, respectivement 38, 39, en série avec un générateur de courant, respectivement 33, 34. Le premier signal constituant du signal différentiel "haut", $1_H$, et le premier signal constituant du signal différentiel "bas", $1_L$, sont respectivement prélevés à la borne du haut et à celle du bas de la résistance 38, qui est une fraction de la charge du premier étage suiveur. Le second signal constituant du signal différentiel "haut", $2_H$, et le second signal constituant du signal différentiel "bas", $2_L$, sont respectivement prélevés à la borne du haut et à celle du bas de la résistance 39, qui est une fraction de la charge du second étage suiveur. Les résistances 38 ou 39 pourraient aussi bien être remplacées par d'autres types de charges, tels que des transistors montés en diode.

Deux paires différentielles sont munies chacune d'un premier transistor, respectivement 20 et 23, et d'un second transistor, respectivement 21 et 22. La base du premier transistor 20 de la première paire recoit le premier signal haut $1_H$, et celle du second transistor 21 recoit le second signal bas $2_L$, la base du premier transistor 23 de la seconde paire recoit le second signal haut $2_H$, et celle du second transistor 22 recoit le premier signal bas $1_L$.

Les collecteurs des seconds transistors 21, 22 des deux paires sont reliés ensemble à un miroir de courant qui comprend un transistor 25 générateur de courant, et un transistor 24 monté en diode, dont l'anode est reliée à la borne d'alimentation VCC, et dont la cathode est reliée à la masse par une source de courant 36. Il passe dans la diode 24 un courant composé du courant de la source 36, auquel s'ajoute éventuellement un courant supplémentaire en provenance des transistors 21 ou 22. Le courant du transistor 25 est "retourné" à son tour dans un miroir de courant constitué par les transistors 29 et 30.

Le courant supplémentaire ci-dessus est fonction de la somme de deux termes :

.   d'une part la différence entre le premier signal haut $1_H$, qui est un constituant du signal différentiel haut, et le second signal bas $2_L$, qui est un constituant du signal différentiel bas,

.   d'autre part la différence entre le second signal haut $2_H$, qui est un constituant du signal différentiel haut, et le premier signal bas $1_L$, qui est un constituant du signal différentiel bas.

Si l'on intervertissait les signaux appliqués aux entrées Vi et Vr, ce seraient les collecteurs des premiers transistors 20, 23 de chaque paire qui devraient être reliés au transistor 24.

Un amplificateur différentiel, pour amplifier le signal de régulation, est constitué par les transistors 26 et 27. Son gain est fonction du courant injecté dans ses émetteurs. Ce courant, appelé courant de commande, est celui reproduit par les miroirs de courant 24, 25 et 29, 30. La sortie de l'amplificateur 26, 27 est réalisée, de façon connue, par un miroir de courant fait de deux transistors de type MOSFET 31, 32 dont les espaces drain-source sont placés dans les trajets allant des collecteurs des transistors 26 et 27 vers l'alimentation VCC. Le courant ainsi délivré permet de charger ou décharger la capacité 7 (la même que sur la figure 1).

Un transistor 28, dont la base est connectée à une borne de commande d'activation Vc, est branché entre VCC et les émetteurs des transistors 26, 27. Il permet de dériver un courant pour désactiver le montage, et l'entrée Vc correspond à la commande 15 de la figure 1.

Le fonctionnement va être illustré, en supposant par exemple que le décalage de tension aux bornes de la résistance 38, ou de la résistance 39, est de 0.6 volt, dans trois cas particuliers, à partir desquels il est évident d'interpoler :

1) supposons d'abord que Vi = Vr . Les signaux $1_H$ et $2_H$ ont la même valeur, par exemple 2 volt, et les signaux $1_L$ ou $2_L$ ont aussi tous les deux la même valeur, décalée de - 0.6 volt, soit 1.4 volt. Les tensions appliquées aux bases des transistors 20, 21, 22, 23 sont respectivement 2, 1.4, 1.4, 2. Les transistors 20 et 23 sont conducteurs, les transistors 21 et 22 sont bloqués. Le courant dans le miroir 24, 25 est seulement celui de la source 36.

2) supposons ensuite que $1_H$ ait la valeur 2.3 volt et que $2_H$ ait la valeur 1.7 volt, soit en gros une tension base-émetteur de moins. Avec toujours un décalage de -0.6 volt dans les résistances 38 ou 39, le signal $1_L$ a la valeur 1.7 volt et le signal $2_L$ a la valeur 1.1 volt, les tensions appliquées aux bases des transistors 20 et 21 sont respectivement de 2.3 volt (1¦H) et de 1.1 volt (2¦L), tout le courant passe par le transistor 20. Les tensions appliquées aux bases des transistors 22 et 23 sont respectivement de 1.7 volt (1¦L) et de 1.7 volt (2¦H), le courant de la source 37 se partage également entre les transistors 22 et 23, et un courant s'ajoute au courant de la source 36 dans le miroir 24, 25.

3) pour des valeurs inverses, soit 1¦H valant 1.7 volt et 2¦H valant 2.3 volt, le courant de la source 35 se partage entre les transistor 20 et 21, et un courant s'ajoute, là encore, au courant de la source 36.

Il apparaît donc que, pour une plage du signal différentiel de régulation centrée autour de zéro, c'est-à-dire pour Vi voisin de Vr, le courant dans la paire de transistors 26, 27 est celui de la source 36, recopié par les miroirs. Lorsque le signal différentiel de régulation s'éloigne de zéro, c'est-à-dire lorsque Vi s'éloigne de Vr, dans un sens comme dans l'autre, un courant passant par le transistor 21 ou par le transistor 22, selon le sens de la différence entre Vi et Vr, vient s'ajouter au courant dans la paire de transistors 26, 27, et de ce fait le gain de cette paire est plus grand. Avec un tel circuit, le changement de pente de la courbe représentant le gain de l'amplificateur différentiel 5 se produit progressivement dans une plage de tension du signal de régulation d'environ 15 mV de largeur.

Des variantes conservant le bénéfice de l'invention, à savoir la non-linéarité, sont possibles. L'adaptateur d'impédance 3 n'est pas indispensable, ni celle des amplificateurs 4 ou 2, et la résistance R peut être reliée directement à une tension d'alimentation. En outre, dans un autre montage appelé "clamp série", la capacité de stockage est montée en série dans la connexion allant de l'entrée RGB à l'entrée de l'amplificateur 2 (il n'y a pas d'amplificateur 1). Dans ce cas, la sortie du module de régulation est connectée au point commun entre la capacité de stockage et l'entrée de l'amplificateur 2. Le module doit alors agir en sens inverse.

**Revendications**

1. Dispositif d'alignement d'un niveau de tension continue, présentant une entrée dite analogique destinée à recevoir une tension analogique d'entrée et une sortie numérique destinée à délivrer un signal numérique résultant d'une conversion analogique/numérique d'une tension analogique obtenue à partir de la tension d'entrée, comprenant :

. un convertisseur analogique/numérique muni d'une entrée analogique reliée à l'entrée du dispositif et reliée via une capacité dite de stockage à une source de potentiel continu fixé, et d'une sortie constituant la sortie du dispositif, et

. un module de régulation, muni d'un comparateur analogique recevant en entrée un signal différentiel dit de régulation constitué d'un premier signal qui est un signal de valeur fixe prédéterminée et d'un second signal qui est un signal représentatif du signal d'entrée du convertisseur, ce module de régulation délivrant en sortie un signal permettant l'ajustement de la tension aux bornes de la capacité de stockage, et étant activé lorsque la tension analogique d'entrée présente un palier dit de référence,

**caractérisé en ce que** le comparateur du module de régulation présente une réponse non-linéaire, avec un gain sortie/entrée diminué pour une plage déterminée du signal différentiel de régulation, plage centrée autour de zéro.

2. Dispositif selon la revendication 1, **caractérisé en ce que** le module de régulation comprend

. des moyens pour engendrer à partir du premier et du second signal constituant le signal différentiel de régulation, deux signaux différentiels décalés, en tension continue, l'un par rapport à l'autre, l'un étant appelé "haut" et l'autre "bas", chacun étant constitué d'un premier et d'un second signal, correspondant respectivement au premier signal et au second signal constituants du signal différentiel de régulation,

. des moyens pour engendrer un courant, dit de commande, qui est fonction de la somme de deux termes : d'une part la différence entre le premier signal constituant du signal différentiel haut et le second signal constituant du signal différentiel bas, d'autre part la différence entre le second signal constituant du signal différentiel haut et le premier signal constituant du signal différentiel bas,

. et un amplificateur différentiel, dont le gain est fonction du dit courant de commande, pour amplifier le signal différentiel de régulation.

3. Dispositif selon la revendication 2, **caractérisé en ce que** les moyens pour engendrer deux signaux différentiels décalés comprennent, pour chacun des premier et second signaux constituant le signal différentiel de régulation, un premier et un second étage de type dit "suiveur", chacun muni d'une charge fractionnée, le premier signal constituant du signal différentiel haut et le premier signal constituant du signal différentiel bas étant respectivement prélevés aux bornes d'une fraction de la charge du premier étage suiveur, le second signal constituant du signal différentiel haut et le second signal constituant du signal différentiel bas étant respectivement prélevés aux bornes d'une fraction de la charge du second étage suiveur.

**4.** Dispositif selon la revendication 2, **caractérisé en ce que** les moyens pour engendrer le courant de commande comprennent deux paires de transistors, dites paires différentielles, munies chacune d'un premier et d'un second transistor, la base du premier transistor de la première paire recevant le premier signal constituant du signal différentiel haut, et celle du second transistor recevant le second signal constituant du signal différentiel bas, la base du premier transistor de la seconde paire recevant le second signal constituant du signal différentiel haut, et celle du second transistor recevant le premier signal constituant du signal différentiel bas, les courants de collecteur des premiers / seconds transistors des deux paires étant ajoutés l'un à l'autre.

**5.** Dispositif selon la revendication 2, **caractérisé en ce que** l' amplificateur différentiel comprend une paire de transistors, dite paire différentielle, le signal différentiel de régulation étant appliqué à ses entrées, paire dans laquelle les émetteurs des deux transistors reliés l'un à l'autre reçoivent le dit courant de commande, éventuellement reproduit au moyen de miroirs de courant.

**6.** Dispositif selon la revendication 5, **caractérisé en ce que** les deux transistors de la paire différentielle sont chargés chacun par un transistor de charge, les deux transistors de charge formant ensemble un miroir de courant, de façon que l'amplificateur différentiel présente une sortie de courant, et une armature de la capacité de stockage est reliée à cette sortie de courant.

**7.** Dispositif selon l'une quelconque des revendications précédentes, **caractérisé en ce que** l'entrée analogique du convertisseur analogique/numérique est reliée à l'entrée analogique du dispositif via une capacité et à une entrée dite de référence, destinée à recevoir une tension de référence, via une résistance.

**8.** Dispositif selon l'une quelconque des revendications précédentes, **caractérisé en ce qu'**un deuxième amplificateur différentiel est placé entre l'entrée analogique du convertisseur analogique/numérique et l'entrée analogique du dispositif, amplificateur présentant une première entrée reliée à l'entrée du dispositif et une deuxième entrée reliée à une borne d'alimentation via la capacité de stockage, et une sortie reliée à l'entrée du convertisseur analogique/numérique.

**9.** Dispositif selon l'une quelconque des revendications précédentes, **caractérisé en ce que**, le convertisseur analogique/numérique étant muni d'une échelle de résistances soumise à une différence de potentiel donnée, échelle fournissant à chaque noeud intermédiaire entre deux résistances une tension dite de référence d'échelle utilisée par le convertisseur à des fins de comparaison avec un signal reçu sur son entrée analogique, le signal de régulation est élaboré à partir d'au moins une des dites tensions de référence d'échelle.

**10.** Dispositif selon la revendication 9, **caractérisé en ce que** l'un des signaux constituants du signal de régulation est l'une des tensions de référence d'échelle.

FIG. 1

FIG. 2

Office européen
des brevets

**RAPPORT DE RECHERCHE EUROPEENNE**

Numéro de la demande

EP 97 20 3201

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | US 5 319 450 A (TAMAYAMA HIROSHI  ET AL) 7 juin 1994<br>* colonne 10, ligne 41 - colonne 12, ligne 56; figure 5 *<br>---- | 1,7-10 | H03M1/06<br>H04N5/18<br>H04N9/72<br>G06G7/20 |
| Y | DE 37 44 076 A (BROADCAST TELEVISION SYST) 13 juillet 1989<br>* colonne 1, ligne 61 - colonne 3, ligne 35; figure 1 *<br>--- | 1 | |
| A | US 4 585 961 A (DAUBERT STEVEN J) 29 avril 1986<br>* abrégé; figures 1,2 *<br>--- | 2 | |
| Y | EP 0 341 326 A (ANT NACHRICHTENTECH) 15 novembre 1989<br>* colonne 2, ligne 3 - colonne 3, ligne 22; figure 1 *<br>--- | 7,8 | |
| D,Y | US 5 371 552 A (BRUMMETTE STEVEN C  ET AL) 6 décembre 1994<br>* colonne 7, ligne 44 - colonne 8, ligne 59; figure 2 *<br>----- | 9,10 | **DOMAINES TECHNIQUES RECHERCHES** (Int.Cl.6)<br><br>H03M<br>H04N<br>G06G |

Le présent rapport a été établi pour toutes les revendications

| Lieu de la recherche | Date d'achèvement de la recherche | Examinateur |
|---|---|---|
| LA HAYE | 9 décembre 1997 | Beindorff, W |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...................................................................
& : membre de la même famille, document correspondant

EPO FORM 1503 03.82 (P04C02)